# FASCICULE DE BREVET EUROPEEN

(11) **EP 1 944 615 B1**
(45) Date de publication et mention de la délivrance du brevet: **05.05.2010**
(21) Numéro de dépôt: 08100219.8
(22) Date de dépôt: 08.01.2008
(51) Int. Cl.: G01R 31/3185

(54) **Détection d'un dysfonctionnement d'un compteur numérique**
Erkennung von Funktionsstörungen eines digitalen Zählers
Detection of a malfunction of a digital counter

(30) Priorité: 10.01.2007 FR 0752600
(43) Date de publication de la demande: 16.07.2008
(73) Titulaire: STMicroelectronics S.A., 92120 Montrouge (FR)
(72) Inventeur: Roquelaure, Philippe, 13320, BOUC BEL AIR (FR)
(74) Mandataire: de Beaumont, Michel

(56) Documents cités:
- US-A- 4 189 635
- US-A- 5 481 580
- MAHESHWARI A ET AL: "Trading off reliability and power-consumption in ultra-low power systems" QUALITY ELECTRONIC DESIGN, 2002. PROCEEDINGS. INTERNATIONAL SYMPOSIUM ON 18-21 MARCH 2002, PISCATAWAY, NJ, USA,IEEE, 18 mars 2002 (2002-03-18), pages 361-366, XP010589387 ISBN: 0-7695-1561-4

## Description

### Domaine de l'invention

La présente invention concerne de façon générale des circuits électroniques et, plus particulièrement, les compteurs numériques cadencés par une horloge.

La présente invention s'applique plus particulièrement à détecter un éventuel dysfonctionnement d'un compteur dans un circuit électronique.

### Exposé de l'art antérieur

Les compteurs intégrés dans des circuits électroniques sont généralement réalisés sous la forme d'un ensemble de bascules qui sont soit initialisées à zéro soit pré-chargées pour que le compteur représente une valeur donnée. Selon les cas, le compteur est incrémenté ou décrémenté à chaque front d'une direction donnée (montante ou descendante) d'un signal d'horloge.

Les compteurs des circuits électroniques ont des utilisations multiples. Par exemple, ils peuvent servir à cadencer une unité centrale de traitement (compteur programme), à compter un nombre d'événements se produisant dans un circuit intégré, que ce soit ou non pour conditionner la suite du fonctionnement du circuit, etc.

Il serait souhaitable de pouvoir détecter un éventuel dysfonctionnement d'un compteur dans un circuit intégré.

Selon un premier exemple d'application, une perturbation du fonctionnement d'un compteur peut conduire à modifier le fonctionnement d'une unité de traitement d'un programme. Une telle perturbation peut être accidentelle ou volontaire (injection de fautes) en particulier dans des applications cryptographiques ou sécurisées de fonctionnement d'un circuit intégré.

Selon un autre exemple d'application, il serait souhaitable de pouvoir détecter d'éventuelles dérives d'une horloge servant à cadencer le fonctionnement d'un circuit..

Le document US-A-4 189 635 décrit un circuit d'autotest utilisant deux compteurs et comparant les résultats fournis par ces deux compteurs pour s'assurer qu'ils suivent les mêmes comptes.

### Résumé de l'invention

Un mode de réalisation de la présente invention vise à détecter un dysfonctionnement d'au moins un compteur.

Un mode de réalisation de la présente invention vise à détecter une dérive d'un signal périodique.

Un mode de réalisation de la présente invention vise également à fournir une information sur la source d'un dysfonctionnement d'un compteur.

Pour atteindre tout ou partie de ces objets ainsi que d'autres, un mode de réalisation de la présente invention prévoit un procédé de détection d'un dysfonctionnement d'au moins un premier compteur commandé par un premier signal, dans lequel :
un deuxième compteur, commandé par un deuxième signal identique au premier signal ou à son inverse et comptant dans le sens inverse par rapport au premier compteur, est initialisé avec une valeur complémentaire à une valeur d'initialisation du premier compteur ;
les valeurs courantes respectives des premier et deuxième compteurs sont sommées ; et
la somme courante est comparée à au moins une valeur représentant la plus grande des valeurs d'initialisation ou cette plus grande valeur majorée d'une unité.

Selon un mode de mise en oeuvre, les signaux de commande sont périodiques.

Selon un mode de mise en oeuvre, la somme des valeurs respectives des deux compteurs est comparée à deux valeurs correspondant respectivement à la plus grande des valeurs d'initialisation des compteurs et à cette plus grande valeur majorée de l'unité, les comparaisons étant respectivement synchronisées sur des fronts inverses du premier signal.

Selon un mode de mise en oeuvre, le premier compteur est initialisé à zéro, le deuxième compteur étant initialisé à la valeur de comptage maximale du premier.

Un mode de mise en oeuvre de l'invention prévoit un procédé de protection d'un signal d'horloge d'un circuit électronique, ledit signal d'horloge servant de base à la commande des deux compteurs.

Un mode de mise en oeuvre de l'invention prévoit un procédé de protection d'un compteur contre une violation de sa valeur.

Un mode de réalisation de l'invention prévoit un circuit de détection d'un dysfonctionnement d'au moins un compteur commandé par un premier signal, comportant :
un deuxième compteur propre à être commandé par un deuxième signal identique au premier signal ou à son inverse et à évoluer dans le sens inverse par rapport au premier compteur ;
un additionneur des valeurs courantes respectives des deux compteurs ; et
au moins un comparateur du résultat fourni par l'additionneur par rapport à la plus grande de deux valeurs complémentaires d'initialisation respectives des compteurs ou à cette plus grande valeur majorée de l'unité.

Selon un mode de réalisation, deux comparateurs comparent le résultat de l'additionneur à deux valeurs correspondant respectivement à ladite plus grande des valeurs d'initialisation des compteurs et à cette plus grande valeur majorée de l'unité, les comparaisons étant propres à être respectivement synchronisées sur des fronts inverses du premier signal.

Selon un mode de réalisation, les différents constituants du circuit de détection sont répartis à différents endroits du circuit électronique qui l'intègre.

Selon un mode de réalisation, le circuit de détection est appliqué à la détection d'une ou plusieurs tentatives de perturbation du fonctionnement d'un circuit électronique.

Selon un mode de réalisation, le circuit de détection est appliqué à la détection d'une dérive d'un paramètre environnemental d'un circuit électronique.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente, partiellement et sous forme de blocs, un exemple de circuit électronique ;
la figure 2 est un schéma-bloc d'un mode de réalisation d'un circuit de détection d'un dysfonctionnement d'un compteur ;
la figure 3 représente une bascule constitutive d'un élément d'un compteur ;
les figures 4A, 4B, 4C, 4D, 4E, 4F et 4G illustrent le fonctionnement de la bascule de la figure 3 ;
les figures 5A, 5B, 5C et 5D illustrent un exemple de fonctionnement du circuit de la figure 2 ;
les figures 6A, 6B, 6C et 6D illustrent un autre exemple de fonctionnement du circuit de la figure 2 ;
la figure 7 est un schéma-bloc d'un autre mode de réalisation d'un circuit de détection de dysfonctionnement d'un compteur ;
les figures 8A, 8B, 8C, 8D, 8E, 8F, 8G, 8H, 8I et 8J illustrent le fonctionnement du circuit de la figure 2 ;
la figure 9 illustre le fonctionnement d'un circuit de détection en l'absence de dysfonctionnement ;
la figure 10 illustre le fonctionnement d'un circuit de détection en présence d'un exemple de dysfonctionnement ;
la figure 11 illustre le fonctionnement d'un circuit de détection en présence d'un autre exemple de dysfonctionnement ;
la figure 12 est un schéma-bloc d'un mode de réalisation d'un circuit intégré équipé d'un détecteur de dysfonctionnement d'un compteur ; et
la figure 13 illustre un exemple d'application à une détection d'une dérive d'un signal périodique.

De mêmes éléments ont été désignés par les mêmes références aux différentes figures.

### Description détaillée

La présente invention sera décrite par la suite en relation avec un exemple d'application à la détection d'une perturbation dans le fonctionnement d'un circuit électronique intégrant un compteur (par exemple, une injection de faute). Elle s'applique toutefois plus généralement à toute détection de dysfonctionnement d'un compteur ou de son signal de cadencement qu'il s'agisse d'un dysfonctionnement accidentel ou provoqué.

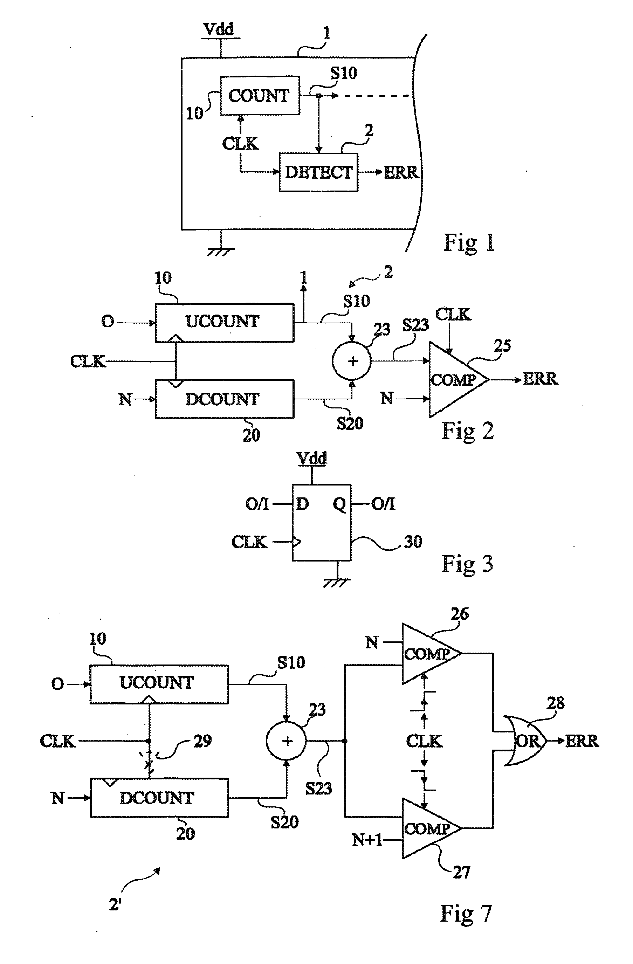

La figure 1 est un schéma-bloc partiel d'un circuit électronique 1 comportant un compteur 10 dont on souhaite détecter un éventuel dysfonctionnement. Le compteur 10 (COUNT) est déclenché par un signal CLK (par exemple, périodique). Une sortie S10 du compteur 10 fournissant sa valeur courante est fournie non seulement à des éléments non représentés du circuit 1 pour exploitation (par exemple, une unité centrale de traitement, un processeur, etc.), mais également à un circuit 2 de détection (DETECT) d'un éventuel dysfonctionnement. Le circuit 2 reçoit le même signal de cadencement CLK que le compteur 10 et fournit, par exemple, un bit ERR indicateur d'un dysfonctionnement du compteur 10. Le compteur 10 et le circuit de détection 2 sont alimentés par une tension continue Vdd correspondant, par exemple, à la tension d'alimentation ou à l'une de plusieurs tensions d'alimentation du circuit 1.

La figure 2 est un schéma-bloc d'un mode de réalisation d'un circuit 2 de détection d'un éventuel dysfonctionnement d'un compteur 10. On suppose le cas d'un compteur 10 incrémenté (UCOUNT) à chaque période d'un signal d'horloge CLK et initialisé à une valeur nulle (0). Le compteur 10 est destiné à compter jusqu'à un compte maximum N. Sa sortie S10 fournit sa valeur courante au reste du circuit 1.

Selon ce mode de réalisation, le détecteur 2 comprend un décompteur 20 (DCOUNT) initialisé à une valeur N correspondant au compte final susceptible d'être atteint par le compteur 10 et déclenché par le même signal CLK (ou son inverse). Les valeurs courantes respectives S10 et S20 des compteurs 10 et 20 sont sommées (additionneur 23) et le résultat de cette somme est comparé (comparateur 25) par rapport à une valeur N. La comparaison s'effectue par exemple sur les fronts descendants du signal CLK. En cas d'inégalité entre les valeurs présentes sur ses deux entrées, le comparateur 25 fournit un signal ERR indicateur d'un dysfonctionnement du compteur 10, c'est-à-dire d'une erreur dans son comptage. En variante, le comparateur 25 compare, sur les fronts montants du signal CLK, le résultat de la somme par rapport à la valeur N. L'additionneur 23 est, par exemple, un ensemble de portes logiques de type OU combinant deux à deux les bits des différents rangs des deux compteurs 10 et 20. Le comparateur 25 est par exemple un comparateur logique combinant les résultats des sommes bit à bit. En variante, les fonctions d'addition et de comparaison peuvent être combinées.

S'ils sont commandés par un signal identique, qu'il soit périodique ou non, deux compteurs fonctionnant en sens inverse, c'est-à-dire l'un décrémentant une valeur maximale (N) et l'autre incrémentant une valeur minimale (0), possèdent à tout moment la totalité de leurs bits respectifs avec des états opposés.

Par conséquent, la somme de leurs deux valeurs courantes est en principe constante (égale à N). Si ce n'est pas le cas, cela signifie que l'un des deux compteurs a subi un dysfonctionnement.

La figure 3 représente le schéma d'une bascule 30 constitutive d'un circuit de comptage. Un compteur 10 ou 20 est en effet réalisé à partir d'une succession de bascules dont les sorties respectives Q fournissent les différents bits du compteur, les bascules étant montées en cascade avec les sorties Q des bascules de rang précédent fournies en entrées D des bascules de rang suivant, le cas échéant en étant combinées par une porte ET avec le résultat de la bascule de rang encore précédent. Il s'agit là d'un compteur synchrone. Il existe également des compteurs asynchrones dans lesquels seule la première bascule reçoit un signal déclencheur, chaque autre bascule étant déclenchée par la sortie de la bascule de rang précédent et toutes les entrées des bascules recevant un niveau haut.

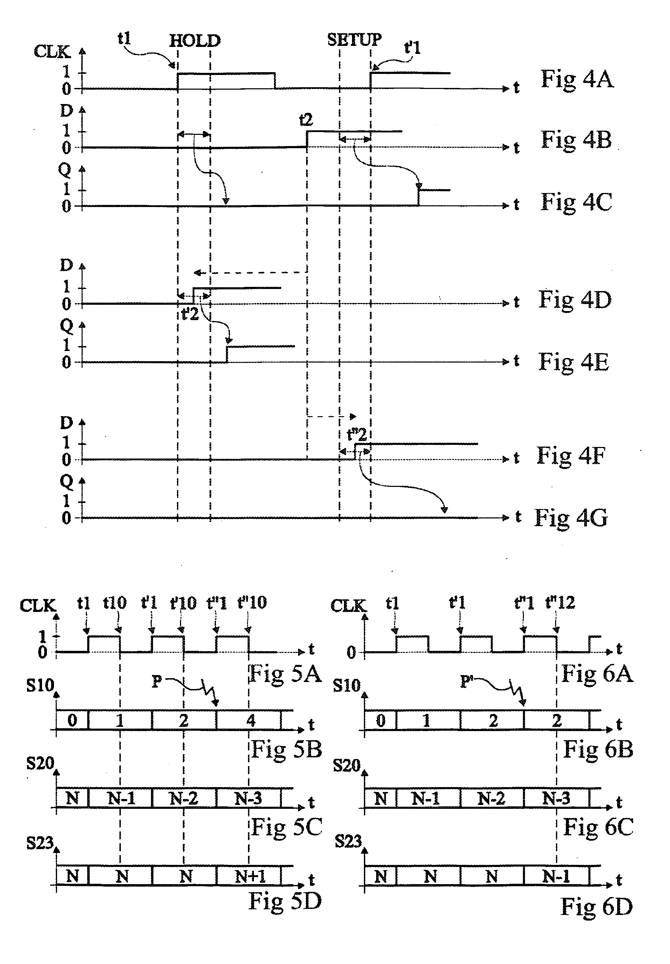

Les figures 4A à 4G illustrent le fonctionnement d'une bascule 3 d'un compteur synchrone lors d'un changement d'état. La figure 4A représente un exemple d'allure du signal d'horloge CLK. Les figures 4B et 4C illustrent un fonctionnement normal de la bascule. Les figures 4D et 4E illustrent un dysfonctionnement de la bascule se produisant pendant son temps de maintien (HOLD) qui correspond à la durée nécessaire après un front déclencheur (par exemple, montant) du signal d'horloge pour garantir qu'un changement d'état de l'entrée D de la bascule soit pris en compte. Les figures 4F et 4G illustrent un autre cas de dysfonctionnement basé sur le temps d'établissement (SETUP) de la bascule qui correspond au temps nécessaire de présence de la donnée en entrée de la bascule avant le front déclencheur du signal CLK pour garantir qu'un changement d'état de l'entrée D de la bascule soit pris en compte.

En fonctionnement normal (figures 4B et 4C), à chaque front montant (instant t1, t'1) du signal CLK, l'état de la donnée présente sur l'entrée D est transféré sur la sortie Q. Dans l'exemple des figures 4B et 4C, on suppose un état zéro au premier front t1 et un état 1 au deuxième front t'1, suite à un changement d'état de l'entrée D à un instant t2. Pour que les données soient prises en compte, il faut que les états respectifs 0 et 1 soient présents suffisamment longtemps avant le front déclencheur (durée au moins égale au temps d'établissement SETUP de la bascule) et soient présents suffisamment longtemps après ce front déclencheur (au moins pendant une durée correspondant au temps de maintien HOLD). Les temps d'établissement et de maintien sont des paramètres caractéristiques des bascules qui dépendent, entre autres, de paramètres de fabrication.

Si l'instant t2 de changement d'état de la donnée D est avancé d'une durée telle qu'il se produit à un instant t'2 (figure 4D) pendant le temps de maintien lié au front d'horloge t1 précédent, cela risque de conduire à un changement d'état de la sortie Q (figure 4E) de la bascule, d'où une modification de la valeur courante du compteur.

A l'inverse, si la donnée D (figure 4F) est retardée d'une durée suffisante, de sorte que ce changement intervient (instant t"2) après le début du temps d'établissement SETUP lié au front suivant t'1 du signal d'horloge, cela risque d'empêcher la prise en compte du changement d'état sur la sortie Q (figure 4G) et perturber là aussi la valeur de la bascule.

Dans le premier cas d'accélération des données (figures 4D et 4E), cela conduit à un incrément anticipé de la valeur du compteur, ce qui fausse sa valeur.

Dans le second cas de décélération des données (figures 4F et 4G), cela conduit à une absence d'incrément du compteur, ce qui fausse également sa valeur. Le même phénomène se produit en cas d'accélération du signal d'horloge CLK.

Le signal CLK n'est pas nécessairement périodique, pourvu que les deux compteurs 10 et 20 soient commandés par le même signal ou par ce signal et son inverse. Pour simplifier, on fera par la suite référence à un signal d'horloge.

Les figures 5A à 5D et 6A à 6D sont des chronogrammes illustrant le fonctionnement du circuit de la figure 2. Les figures 5A et 6A illustrent un exemple de signal CLK. Les figures 5B et 6B illustrent des exemples de valeurs prises par le compteur 10. Les figures 5C et 6C illustrent des exemples de valeurs prises par le compteur 20. Les figures 5D et 6D illustrent des exemples de valeurs prises par la sortie S23 de l'additionneur 23.

En fonctionnement normal, le compteur 10 est incrémenté sur les fronts montants (instants t1, t'1) du signal d'horloge et prend donc successivement les valeurs 0, 1 et 2. Dans l'exemple représenté, le compteur 20 est décrémenté également sur les fronts montants de ce signal d'horloge et prend donc successivement les valeurs N, N-1 et N-2. Dans un fonctionnement normal, la somme des comptes des deux compteurs 10 et 20 est constante et égale à la valeur N. Le comparateur 25, échantillonné dans cet exemple sur les fronts descendants t10, t'10 vérifie le résultat S23 de l'additionneur 23 par rapport à la valeur N.

Les figures 5A à 5D illustrent un exemple de dysfonctionnement (perturbation P) provoquant un incrément anticipé du compteur 10 qui prend la valeur 2 suite au front d'horloge t"1. La perturbation P peut être détectée dès l'instant t"10 dans la mesure où la somme S23 fournie par l'additionneur 23 est N+1.

Les figures 6A à 6D illustrent un autre exemple de dysfonctionnement (perturbation P') correspondant à une absence d'incrément du compteur 10 à l'instant t"1 qui conserve la valeur 2. La somme S23 fournit alors la valeur N-1. Là encore, l'échantillonnage sur les fronts descendants de cette somme S23 permet de détecter le dysfonctionnement dès l'instant t"10.

La figure 7 représente un autre mode de réalisation d'un circuit 2' de détection. Un premier compteur 10 (UCOUNT) incrémenté sous commande d'un signal CLK, par exemple périodique, est initialisé à une valeur 0 tandis qu'un deuxième compteur 20 (DCOUNT) décrémenté sans commande du signal CLK ou de son inverse (inverseur 29 en pointillés) est initialisé à une valeur N, correspondant au compte maximum du compteur 10 (fixé par son nombre de bascules en cascade initialisées à l'état haut). Les sorties courantes respectives S10 et S20 des compteurs 10 et 20 sont sommées. Deux comparateurs 26 et 27 sont utilisés pour comparer l'état courant du signal S23 de sortie du sommateur 23, respectivement par rapport à la valeur N et par rapport à la valeur N+1. Les comparateurs 26 et 27 sont respectivement échantillonnés sur les fronts montants et descendants du signal CLK. Les sorties des comparateurs 26 et 27 sont combinées par une porte OU 28 (OR) fournissant le signal résultat de détection ERR.

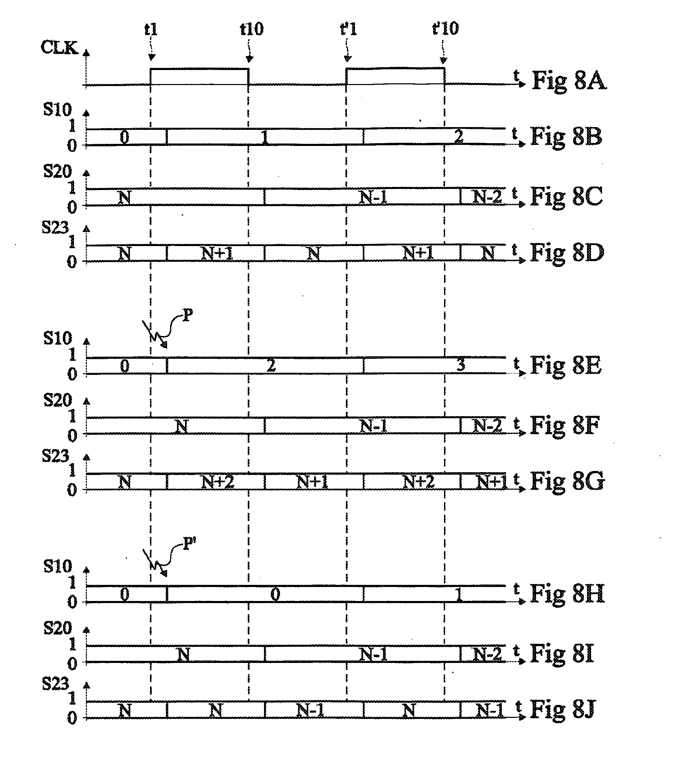

Les figures 8A à 8J illustrent le fonctionnement d'un circuit de détection tel que représenté en figure 2. On suppose un signal d'horloge CLK (figure 8A) stable. Les figures 8B, 8E et 8H illustrent des exemples de valeurs prises par le compteur 10. Les figures 8C, 8F et 8I illustrent des exemples de valeurs prises par le compteur 20. Les figures 8D, 8G et 8J illustrent des exemples de valeurs prises par la sortie S23 de l'additionneur 23.

En fonctionnement normal, le compteur 10 est incrémenté, par exemple, sur les fronts montants (instants t1, t'1) du signal d'horloge et prend donc successivement les valeurs 0, 1 et 2. Dans l'exemple des figures 8A à 8J, le compteur 20 est décrémenté sur les fronts descendants (instants t10, t'10) de ce signal d'horloge et prend donc successivement les valeurs N, N-1 et N-2. Aux chronogrammes des figures 8A à 8J, un léger décalage temporel entre le changement de valeur des compteurs 10 et 20 par rapport aux fronts respectivement montants et descendants du signal d'horloge a été illustré pour figurer un temps de propagation. Quel que soit le temps de propagation des signaux, celui-ci est régulier dans un fonctionnement normal et sa valeur n'a en elle-même par d'importance.

Dans un fonctionnement normal tel qu'illustré aux figures 8B à 8D, la somme des comptes des deux compteurs 10 et 20 prend successivement les valeurs N, N+1, N, N+1, N etc. Par conséquent, en échantillonnant le comparateur sur les fronts de même type du signal d'horloge, on obtient une valeur constante du compteur. Dans la représentation de la figure 7, les comparateurs 26 et 27 vérifient le résultat S23 par rapport aux valeurs successives N et N+1 que doit prendre la somme des états.

Les figures 8E à 8G illustrent un premier cas de dysfonctionnement (perturbation P) provoquant un incrément anticipé du compteur 10 qui prend, dans cet exemple, la valeur 2 suite au front d'horloge t1, puis la valeur 3 suite au front d'horloge t'1, etc. La perturbation P peut être détectée dès l'instant t10 dans la mesure où les états respectifs en sortie du sommateur 23 deviennent N, N+2, N+1, N+2, N+1, etc.

Les figures 8H à 8J illustrent un autre exemple de dysfonctionnement (perturbation P') correspondant à une absence d'incrément du compteur 10 à l'instant t1. Le compteur 10 prend alors la valeur 0 suite au front d'horloge t1, puis la valeur 1 suite au front d'horloge t'1, etc. Par conséquent, la somme S23 fournit respectivement les valeurs N, N, N-1, N, N-1, etc. Là encore, l'échantillonnage sur les fronts descendants de cette somme S23 permet de détecter le dysfonctionnement dès l'instant t10.

On notera que la détection d'erreur est valable quelles que soient les valeurs prises par les compteurs suite à la perturbation, c'est-à-dire quelle que soit l'influence du dysfonctionnement.

Le fait de déclencher les compteurs 10 et 20 sur les fronts d'horloge inverses l'un par rapport à l'autre améliore les possibilités de détection en évitant qu'une perturbation se traduisant de la même façon sur les deux compteurs ne soit pas prise en compte.

Selon un exemple d'application, le détecteur détecte des perturbations dans le signal d'horloge CLK, par exemple provoquées par des attaques visant à perturber le fonctionnement du circuit intégré en cherchant à perturber l'horloge de synchronisation du circuit.

Selon un autre exemple d'application (combinable au premier), le détecteur détecte des dysfonctionnements (par exemple, des attaques par injection de faute) provoqués directement par des forçages de valeurs des bascules d'un des compteurs. De tels forçages peuvent être effectués pour porter toutes les bascules à l'état haut (attaques positives) ou à l'état bas (attaques négatives) et cherchent, par exemple, à forcer la réinitialisation d'un compteur.

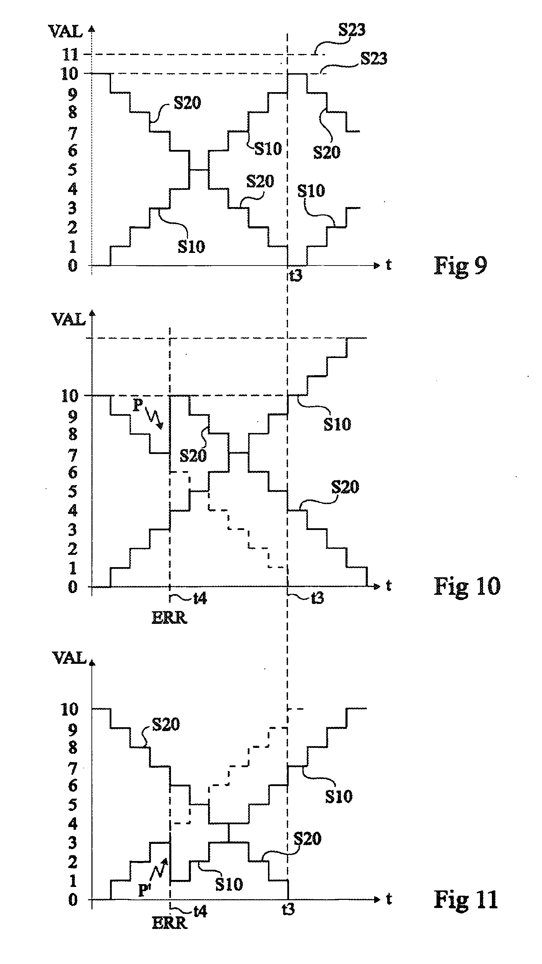

Les figures 9 à 11 illustrent, par des exemples simplifiés de faibles valeurs de comptage (N = 10), le fonctionnement d'un circuit de détection. Ces figures sont des chronogrammes illustrant l'évolution des valeurs courantes VAL prises par les compteurs 10 et 20.

La figure 9 illustre un exemple de fonctionnement normal dans lequel le compteur 10, initialisé à la valeur 0, atteint à un instant t3 la valeur 10 tandis que le compteur 20 initialisé avec la valeur 10, atteint 0 à cet instant t3. S'il s'agit d'un compteur temporel, le compteur 10 recommence à compter à partir de 0 après l'instant t3. Les sommes des valeurs respectives des compteurs 10 et 20 fournissent soit la valeur 10, soit la valeur 11, selon que l'échantillonnage est effectué sur les fronts montants (valeur 10) ou sur les fronts descendants (valeur 11).

La figure 10 illustre un exemple où, lorsqu'il a atteint la valeur 7 (instant t4), le compteur 20 est, sous l'effet d'une perturbation P, réinitialisée à la valeur 10 alors que l'évolution du compteur 10 n'est pas modifiée. Les allures du fonctionnement normal (figure 9) sont reprises en pointillés. Dès l'instant t4 (à une demi-période près du signal d'horloge), le circuit détecte la perturbation. Si rien n'est fait, on voit qu'à la fin théorique t3 du temps de comptage, le compteur atteint sa valeur 10. Toutefois, le compteur 20 atteint alors une valeur erronée (4). Ce cas montre que ce qui a été exposé en relation avec la surveillance du fonctionnement d'un compteur (10) marche aussi pour la surveillance du fonctionnement d'un décompteur (20). De plus, cela illustre le cas de compteurs subissant des perturbations différentes.

La figure 11 illustre un exemple de perturbation P' intervenant sur le compteur 10 à un instant t4 où celui-ci a atteint le compte 3 et retrouve alors la valeur 1. Là encore, le signal d'erreur ERR est obtenu dès l'instant t4 (à la demi période du signal d'horloge près). Si rien n'est fait, le compteur 10 fournit une valeur 7 à la fin (instant t3) de la période de comptage attendue.

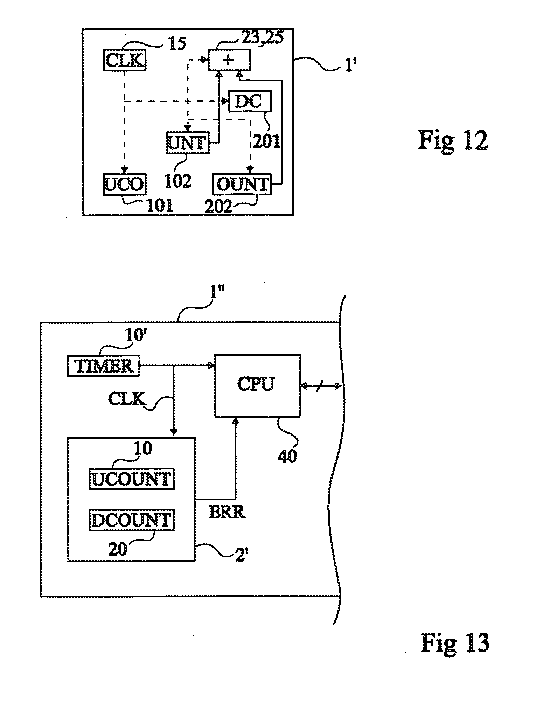

La figure 12 est un schéma-bloc représentant partiellement un exemple de circuit intégré 1' contenant un circuit de détection d'un éventuel dysfonctionnement d'un compteur. Cette figure illustre le cas où les éléments (bascules) constitutifs des compteurs 10 et 20 sont répartis à différents endroits du circuit. Dans cet exemple, une première partie 101 (UCO) du compteur 10 est dissociée d'une deuxième partie 102 (UNT) tandis qu'une première partie 201 du compteur 20 (DC) est dissociée d'une deuxième partie 202 (OUNT) de ce compteur. Les sorties respectives des compteurs sont fournies à l'additionneur 23 symbolisé ici combiné au comparateur 25 (ou aux comparateurs 26 et 27). Toutes les bascules sont commandées par un même signal CLK (bloc 15).

La figure 13 est un schéma-bloc illustrant un exemple d'application de l'invention à la protection d'un signal d'horloge CLK de cadencement d'un circuit électronique 1" représenté partiellement. Par exemple, le signal CLK cadence une unité de traitement 40 (par exemple, l'unité centrale de traitement CPU d'un microprocesseur exécutant des programmes, un circuit de décodage ou de chiffrement en logique câblé, etc.). Le signal CLK est lui-même généralement fourni par un compteur temporel 10' (TIMER) dont une sortie est reliée à une entrée d'horloge de l'unité 40 et qui reçoit un signal d'horloge non représenté (identique ou différent du signal CLK). Le circuit 1" intègre un circuit 2' de détection du type de ceux décrits en relation avec les figures précédentes. Dans l'exemple de la figure 13, on suppose que le circuit 2' intègre les deux compteurs 10 et 20 servant à la détection. Cela montre que les mécanismes de détection peuvent être cascadés dans un même circuit pour contrôler plus de deux compteurs.

Un avantage d'un circuit de détection de dysfonctionnement est qu'il peut détecter une tentative de perturbation sur une horloge d'un circuit, que cette perturbation soit accidentelle ou volontaire (tentative de piratage d'un circuit dit sécurisé, par exemple une carte à puce ou un circuit de contrôle de droits d'accès de type télévision à péage, téléphonie, internet, etc.).

Un autre avantage est que sa mise en oeuvre est compatible avec tout type de compteur.

Bien entendu, la présente invention est susceptible de diverses variantes et modifications qui apparaîtront à l'homme de l'art.

En particulier, l'exploitation du signal de détection ou l'interprétation des causes possibles d'erreur dépendent de l'application. Par exemple, on pourra ne pas se contenter d'un signal d'erreur mais exploiter le résultat de la somme des valeurs courantes des deux compteurs commandés respectivement sur les fronts montants et descendants d'un même signal pour déterminer la source du dysfonctionnement. Avec une mesure sur fronts descendants, dans le cas d'une valeur N+1, le fonctionnement est normal. Dans le cas d'une valeur N+2, il s'agit d'une accélération des données. Dans le cas d'une valeur N, il s'agit d'une décélération des données ou d'une accélération du signal d'horloge. Dans le cas d'une valeur 0 ou 2N, il s'agit d'une modification (forçage) de la valeur des bascules, respectivement négative ou positive. Pour toutes les autres valeurs, l'origine du dysfonctionnement n'est pas identifiée mais il reste détecté. Une telle interprétation des valeurs permet de distinguer différents cas de dysfonctionnement. Une telle variante est de préférence mise en oeuvre dans une version où les compteurs sont dans une même zone du circuit intégré de façon à subir les éventuelles perturbations de façon homogène.

Par ailleurs, il n'est pas indispensable que les compteurs soient initialisés à leurs comptes maximum et minimum respectifs. Il suffit qu'ils soient initialisés avec des valeurs telles que leur somme soit égale au compte maximum (N) diminuée de la valeur minimale. Cela revient à prévoir des valeurs complémentaires.

De plus, les temps d'établissement et de maintien des différentes bascules constitutives des compteurs sont des caractéristiques susceptibles d'être adaptées lors de la conception du circuit intégré et dépendent, entre autres, d'éléments (inverseurs, lignes à retard, etc.) fixant les temps de propagation. Une telle adaptation permet de régler la sensibilité du détecteur en modifiant les décalages temporels auxquels il est sensible. Un tel réglage de sensibilité peut servir, par exemple, à une mesure de dérives d'un paramètre environnemental ou de fabrication d'un circuit intégré. Par exemple, sachant que les temps d'établissement et de maintien sont sensibles à la température de fonctionnement du circuit, on peut utiliser le détecteur pour détecter si la température de fonctionnement du circuit sort d'une plage fixée par une fenêtre temporelle liée aux temps d'établissement et de maintien. D'autres paramètres environnementaux de fonctionnement du circuit intégré conditionnant ces temps d'établissement et de maintien pourront également être surveillés (par exemple, la tension d'alimentation). Selon un autre exemple, le détecteur est utilisé pour vérifier des conditions de fabrication d'un circuit. On peut en effet définir une plage acceptable de temps d'établissement et de maintien des bascules des compteurs et vérifier, par exemple sur un circuit témoin, que la technologie de fabrication n'a pas subi de dérive en vérifiant que le détecteur ne détecte pas d'erreur de comptage.

En outre, les fonctions respectives des deux compteurs du circuit pourront être inversées, le circuit de détection détectant une divergence entre les deux compteurs. Par exemple, dans une application à la protection d'un compteur contre une violation de sa valeur ou à la protection d'un signal d'horloge, que ce soit par modification d'un signal de cadencement ou par modification des valeurs des bascules, le compteur à protéger peut être indifféremment le compteur ou le décompteur, ou les deux.

Enfin, bien que l'invention ait été décrite en relation avec un exemple de bascules D, elle s'applique à des compteurs réalisés avec n'importe quel type de bascules (par exemple des bascules D, JK, etc.) ou autre circuit réalisant la même fonction, et quelles que soient les sorties (directes ou inverses) utilisées. Par ailleurs, la réalisation des éléments de sommation et de comparaison du détecteur est à la portée de l'homme du métier en utilisant des technologies habituelles de réalisation de telles fonctions, qu'elles soient séparées ou combinées. En particulier, bien que l'invention ait été décrite en relation avec un vocabulaire faisant référence à une réalisation matérielle, l'analyse des valeurs courantes des deux compteurs pourra être effectuée de façon logicielle, en particulier dans le cas où l'on souhaite identifier l'origine du dysfonctionnement.

## Revendications

1. Procédé de détection d'un dysfonctionnement d'au moins un premier compteur (10, 20) commandé par un premier signal (CLK), **caractérisé en ce que** :
un deuxième compteur (20, 10), commandé par un deuxième signal identique au premier signal ou à son inverse et comptant dans le sens inverse par rapport au premier compteur, est initialisé avec une valeur (N) complémentaire à une valeur d'initialisation (0) du premier compteur ;
les valeurs courantes respectives des premier et deuxième compteurs sont sommées (23) ; et
la somme courante (S23) est comparée (25 ; 26, 27) à au moins une valeur représentant la plus grande (N) des valeurs d'initialisation (0, N) ou cette plus grande valeur majorée (N+1) d'une unité.

2. Procédé selon la revendication 1, dans lequel les signaux de commande (CLK) sont périodiques.

3. Procédé selon l'une quelconque des revendications 1 et 2, dans lequel la somme (S23) des valeurs respectives des deux compteurs (10, 20) est comparée (26, 27) à deux valeurs correspondant respectivement à ladite plus grande (N) des valeurs d'initialisation et à cette plus grande valeur majorée (N+1) de l'unité, les comparaisons étant respectivement synchronisées sur des fronts inverses du premier signal (CLK).

4. Procédé selon l'une quelconque des revendications 1 à 3, dans lequel le premier compteur (10) est initialisé à zéro (0), le deuxième compteur (20) étant initialisé à la valeur (N) de comptage maximale du premier.

5. Procédé de protection d'un signal d'horloge (CLK) d'un circuit électronique (1, 1', 1"), **caractérisé en ce qu'**il met en oeuvre un procédé conforme à l'une quelconque des revendications 1 à 4, ledit signal d'horloge servant de base à la commande des deux compteurs (10, 20).

6. Procédé de protection d'un compteur (10) contre une violation de sa valeur, **caractérisé en ce qu'**il met en oeuvre un procédé conforme à l'une quelconque des revendications 1 à 4.

7. Circuit (2, 2') de détection d'un dysfonctionnement d'au moins un compteur (10, 20) commandé par un premier signal (CLK), **caractérisé en ce qu'**il comporte :
un deuxième compteur (20, 10) propre à être commandé par un deuxième signal identique au premier signal ou à son inverse et à évoluer dans le sens inverse par rapport au premier compteur ;
un additionneur (23) des valeurs courantes respectives des deux compteurs ; et
au moins un comparateur (25 ; 26, 27) du résultat fourni par l'additionneur par rapport à la plus grande (N) de deux valeurs complémentaires (0, N) d'initialisation respectives des compteurs ou à cette plus grande valeur majorée (N+1) de l'unité.

8. Circuit selon la revendication 7, dans lequel deux comparateurs (26, 27) comparent le résultat de l'additionneur (23) à deux valeurs correspondant à ladite plus grande (N) des valeurs d'initialisation des compteurs (10, 20) ou à cette plus grande valeur majorée (N+1) de l'unité, les comparaisons étant propres à être respectivement synchronisées sur des fronts inverses du premier signal (CLK).

9. Circuit électronique (1, 1', 1"), **caractérisé en ce qu'**il comporte un circuit de détection (2, 2') conforme à l'une quelconque des revendications 7 et 8.

10. Circuit selon la revendication 9, dans lequel ses constituants sont répartis à différents endroits.

11. Application d'un circuit de détection (2, 2') conforme à l'une quelconque des revendications 7 et 8, à la détection d'une ou plusieurs tentatives de perturbation du fonctionnement d'un circuit électronique (1, 1', 1").

12. Application d'un circuit de détection (2, 2') conforme à l'une quelconque des revendications 7 et 8, à la détection d'une dérive d'un paramètre environnemental d'un circuit électronique (1, 1', 1").

## Claims

1. A method for detecting a malfunction of at least one first counter (10, 20) controlled by a first signal (CLK), **characterized in that**:
a second counter (20, 10), controlled by a second signal identical to the first signal or to its inverse, and counting in the reverse direction with respect to the first counter, is set with a value (N) complementary to a setting value (0) of the first counter;
the respective current values of the first and second counters are added up (23); and
the current sum (S23) is compared (25; 26, 27) with at least one value representing the greatest one (N) of the setting values (0, N) or this greatest value plus one (N+1).

2. The method of claim 1, wherein the control signals (CLK) are periodic.

3. The method of claim 1 or 2, wherein the sum (S23) of the respective values of the two counters (10, 20) is compared (26, 27) with two values respectively corresponding to said greatest one (N) of the setting values of the counters and to this greatest value plus one (N+1), the comparisons being respectively synchronized on inverse edges of the first signal (CLK).

4. The method of any of claims 1 to 3, wherein the first counter (10) is set to zero (0), the second counter (20) being set to the maximum counting value (N) of the first one.

5. A method for protecting a clock signal (CLK) of an electronic circuit (1, 1', 1"), **characterized in that** it implements the method of any of claims 1 to 4, said clock signal being used as a base for the control of the two counters (10, 20).

6. A method for protecting a counter (10) against a violation of its value, **characterized in that** it implements the method of any of claims 1 to 4.

7. A circuit (2, 2') for detecting a malfunction of at least one counter (10, 20) controlled by a first signal (CLK), **characterized in that** it comprises:
a second counter (20, 10) adapted to be controlled by a second signal identical to the first signal or to its inverse and of varying in the reverse direction with respect to the first counter;
an adder (23) of the respective current values of the two counters; and
at least one comparator (25; 26, 27) of the result provided by the adder with respect to the greatest one (N) of two respective complementary setting values (0, N) of the counters or to this greatest value plus one (N+1).

8. The circuit of claim 7, wherein two comparators (26, 27) compare the result of the adder (23) with two values respectively corresponding to said greatest one (N) of the setting values of the counters (10, 20) and with this greatest value plus one (N+1), the comparisons being adapted to be respectively synchronized on inverse edges of the first signal (CLK).

9. An electronic circuit (1, 1', 1"), **characterized in that** it comprises the detection circuit (2, 2') of claim 7 or 8.

10. The circuit of claim 9, wherein its components are distributed at different locations.

11. An application of the detection circuit (2, 2') of claim 7 or 8, to the detection of one or several attempts of disturbance of the operation of an electronic circuit (1, 1', 1").

12. An application of the detection circuit (2, 2') of claim 7 or 8, to the detection of a drift of an environmental parameter of an electronic circuit (1, 1', 1").

## Patentansprüche

1. Ein Verfahren zum Detektieren einer Fehlfunktion wenigstens eines ersten Zählers (10, 20), der durch ein erstes Signal (CLK) gesteuert wird, **dadurch gekennzeichnet, dass** ein zweiter Zähler (20, 10), der durch ein zweites Signal identisch zu dem ersten Signal oder dessen Invers gesteuert wird, und der in die entgegengesetzte Richtung bezüglich des ersten Zählers zählt auf einen Wert (N) gesetzt wird, der komplementär zu einem Einstellwert (0) des ersten Zählers ist;
die jeweiligen derzeitigen Werte des ersten und zweiten Zählers addiert werden (23); und
die derzeitige Summe (S23) verglichen wird (25; 26, 27) mit wenigstens einem Wert, der den größten (N) der Einstellwerte (0, N) oder diesen größten Wert plus 1 (N+1) repräsentiert.

2. Verfahren nach Anspruch 1, wobei die Steuersignale (CLK) periodisch sind.

3. Verfahren nach Anspruch 1 oder 2, wobei die Summe (S23) der jeweiligen Werte der zwei Zähler (10, 20) verglichen wird (26, 27) mit zwei Werten, die jeweils den größten (N) der Einstellwerte der Zähler und diesem größten Wert plus 1 (N+1) entsprechen, wobei der Vergleich jeweils mit den inversen Kanten des ersten Signals (CLK) synchronisiert ist.

4. Verfahren nach einem der Ansprüche 1 bis 3, wobei der erste Zähler (10) auf 0 gesetzt ist, der zweite Zähler (20) auf den Maximalzählwert (N) des ersten Zählers gesetzt ist.

5. Verfahren zum Schutz eines Taktsignals (CLK) einer elektronischen Schaltung (1, 1', 1"), **dadurch gekennzeichnet, dass** es das Verfahren nach einem der Ansprüche 1 bis 4 implementiert, wobei das Taktsignal als eine Basis für die Steuerung der zwei Zähler (10, 20) verwendet wird.

6. Verfahren zum Schutz eines Zählers (10) gegen eine Verletzung seines Werts, **dadurch gekennzeichnet, dass** es das Verfahren nach einem der Ansprüche 1 bis 4 implementiert.

7. Eine Schaltung (2, 2') zum Detektieren einer Fehlfunktion wenigstens eines Zählers (10, 20), der durch eine erstes Signal (CLK) gesteuert wird, **dadurch gekennzeichnet, dass** die Schaltung folgendes aufweist:
einen zweiten Zähler (20, 10), der in der Lage ist, durch ein zweites Signal gesteuert zu werden, das identisch zu dem ersten Signal oder dessen Invers ist, und zum Variieren in der umgekehrten Richtung bezüglich des ersten Zählers;
einen Addierer (23) der jeweiligen derzeitigen Werte der zwei Zähler; und
wenigstens einen Komparator (25; 26, 27) des Ergebnisses, das durch Addierer vorgesehen wird bezüglich des größten (N) der zwei jeweiligen komplementären Einstellwerte (0, N) der Zähler oder dieses größten Wertes plus 1 (N+1).

8. Schaltung nach Anspruch 7, wobei zwei Komparatoren (26, 27) vorgesehen sind, die das Ergebnis des Addierers (23) mit zwei Werten vergleichen, die jeweils dem größten (N) der Einstellwerte der Zähler (10, 20) und diesem größten Wert plus 1 (N+1), wobei der Vergleich in der Lage ist jeweils mit inversen Kanten des ersten Signals (CLK) synchronisiert zu werden.

9. Elektronische Schaltung (1, 1', 1") **dadurch gekennzeichnet, dass** sie die Detektierschaltung (2, 2') nach Anspruch 7 oder 8 aufweist.

10. Schaltung nach Anspruch 9, wobei die Komponenten an unterschiedlichen Orten angeordnet sind.

11. Eine Anwendung der Schutzschaltung (2, 2') nach Anspruch 7 oder 8 für den Schutz gegenüber einem oder mehreren Versuchen der Störung des Betriebs einer elektronischen Schaltung (1, 1', 1").

12. Eine Anwendung der Schutzschaltung (2, 2') nach Anspruch 7 oder 8 für den Schutz eines Drifts eines Umweltparameters einer elektronischen Schaltung (1, 1', 1").
